# EUROPEAN PATENT SPECIFICATION

(11) **EP 1 901 355 B1**
(45) Date of publication and mention of the grant of the patent: **11.11.2015**
(21) Application number: 07075809.9
(22) Date of filing: 17.09.2007
(51) Int. Cl.: H01L 29/739, H01L 29/08, H01L 29/06, H01L 29/775, H01L 29/423, H01L 29/772

(54) **Tunnel effect transistors based on monocrystalline nanowires having a heterostructure**
Tunneleffekttransistoren auf Basis von monokristalline Nanodrahtstrukturen mit Heterostruktur
Transistors à effet tunnel basés sur des nanofils monocristallins ayant une hétérostructure

(30) Priority: 15.09.2006 US 845006 P; 27.11.2006 EP 06024507
(43) Date of publication of application: 19.03.2008
(73) Proprietor: IMEC, 3001 Leuven (BE); K.U. Leuven Research and Development, 3000 Leuven (BE)
(72) Inventor: Verhulst, Anne S., 2234 Houtvenne (BE); Vandenberghe, William G., 3000 Leuven (BE)
(74) Representative: Bird, William Edward

(56) References cited:
- WO-A-02/084757
- WO-A-2006/034887
- WO-A-2006/073477
- US-A1- 2003 116 792
- US-A1- 2004 075 464
- US-A1- 2005 161 662
- US-A1- 2005 181 587

## Description

### FIELD OF THE INVENTION

The present invention is related to the field of semiconductor devices and nanotechnology. More specifically, the invention is related to a nanostructure semiconductor device, more specifically to a tunnel field effect transistor having an elongate monocrystalline heterostructure nanostructure, i.e. nanowire, and a method for manufacturing such tunnel field effect transistor devices with integrated elongate monocrystalline nanostructures.

### BACKGROUND OF THE INVENTION

Microelectronic devices are generally fabricated on semiconductor substrates as integrated circuits. A complementary metal-oxide-semiconductor (CMOS) field effect transistor is one of the core elements of the integrated circuits. Dimensions and operating voltages of CMOS transistors are continuously reduced, or scaled down, to obtain ever-higher performance and packaging density of the integrated circuits.

One of the problems due to the scaling down of CMOS transistors is that the power consumption keeps increasing. This is partly because leakage currents are increasing (e.g. due to short channel effects) and because it becomes difficult to decrease the supply voltage. The latter is mainly due to the fact that the subthreshold slope is limited to at least about 60 mV/decade, such that switching the transistor from ON to OFF needs a certain voltage variation and therefore a minimum supply voltage.

Tunnel field-effect transistors (TFETs) are typically advertised as successors of metal-oxide semiconductor field-effect transistors (MOSFETs), because of their absence of short-channel effects and because of their resulting low off-currents. Another advantage of TFETs is that the subthreshold slope can be less than 60 mV/dec, the physical limit of conventional MOSFETs, such that potentially lower supply voltages can be used. However, TFETs typically suffer from low on-currents, a drawback related to the large resistance of the tunnel barrier.

In US 2005/0274992, a method of fabricating an improved TFET using nanowires is disclosed. The method comprises forming in a nanotube (i.e. a nanowire with axial opening) an n-doped region and a p-doped region that are separated by an undoped channel region of the transistor. Electrical contacts are provided for the doped regions and a gate electrode that is formed upon a gate dielectric layer is deposited on the channel region of the transistor. The proposed structure still has the disadvantage of introducing new materials (carbon nanotubes).

To increase the on-current of a silicon TFET, suggestions have been made in literature by Bhuwalka et al. (IEEE transactions on electron devices Vol 52, No 7, July 2005) to add a small (about 3 nm wide) section of highly-doped Si₁₋ₓGeₓ at the tunnel barrier. The Si₁₋ₓGeₓ has a smaller band gap than Si such that the tunnel barrier width decreases due to the presence of this section. However, these structures with the Si₁₋ₓGeₓ section, can still not compete with conventional MOSFETs because of their low on-currents.

As a conclusion, there is still a need for an improved method of fabricating a nanowire tunnel field effect transistor.

### SUMMARY OF THE INVENTION

It is an object of the present invention to provide good semiconductor device structures according to claim 1. Semiconductor device structures according to embodiments of the present invention have an improved architecture. Semiconductor device structures according to embodiments of the present invention have low power consumption. It is a further object of the present invention to provide a method for the manufacturing of such semiconductor device according to claim 25.

Embodiments of the invention relate to micro- and nanoelectronics and may be used for developing low power semiconductor device structures. Using the tunnel field effect transistor of embodiments of the invention it is possible to further increase the number of transistors on a chip. The elongate monocrystalline nanostructure tunnel field effect transistor, i.e. nanowire tunnel field effect transistor, of some embodiments of the invention can be based on current Si based technology and can therefore be easily incorporated in current devices using current state of the art technologies. The elongate monocrystalline nanostructure tunnel field effect transistor, i.e. nanowire tunnel field effect transistor, according to the invention is distinguished from all analogous TFETs known in prior art by the integration of an appropriate heterosection. A heterosection is a section along the longitudinal axis of an elongate monocrystalline nanostructure, e.g. nanowire, which is made of a material which is different from the material of the main part of the elongate monocrystalline nanostructure. The heterosection can help enable an improved performance in terms of any or all of: high ON currents (the resistance associated with the tunnel barrier can be decreased by using a material with a very small bandgap for the heterosection and/or a material with a different electron affinity for the heterosection than the electron affinity of the material of the main part of the elongate monocrystalline nanostructure), low OFF currents (the OFF-current is determined by the material of the main part of the elongate monocrystalline nanostructure, and can be chosen independently of the material of the heterosection) and fast OFF-to-ON transition (as simulations have indicated, in the presence of a heterosection, whereby the heterosection material has a smaller bandgap than the material of the main part of the elongate monocrystalline nanostructure, or whereby the heterosection material has a different electron affinity from the electron affinity of the material of the main part of the elongate monocrystalline nanostructure, the OFF-to-ON transition becomes faster). The interface between the material of the main part of the elongate monocrystalline nanostructure and the heterosection is substantially defect-free, i.e. it does not result in a highly defective interface, because this is an elongate monocrystalline nanostructure and the very small cross section allows for efficient lateral stress relaxation. An example is a silicon nanowire with a germanium heterosection, where the lattice mismatch between silicon and germanium does not result in a highly defective interface.

In a particular embodiment of the invention, a Tunnel Field Effect Transistor (TFET) semiconductor device is disclosed. Said TFET comprises at least one elongate monocrystalline nanostructure, i.e. nanowire (to form a NW-TFET), comprising a first main electrode region made of first semiconductor material highly doped with dopants of a first conductivity type e.g. p doped (or n doped), a second main electrode region made of a second material different from the first semiconductor material and highly doped with dopants of a second conductivity type, e.g. n doped (or p doped), and a channel region in between the first main electrode region and the second main electrode region, the channel region being of the first semiconductor material and being lowly doped with dopants of either the first or the second conductivity type. The TFET furthermore comprises a control electrode structure at least on the channel region.This embodiment is possible because an elongate monocrystalline nanostructure, e.g. nanowire, can have sufficiently defect-free heterosections of arbitrary length. This embodiment has the advantage that it requires one less processing step in the fabrication of the Tunnel Field Effect Transistor (NW-TFET), as the first main electrode region and the channel region are made of only one material.

The control electrode structure may completely cover the channel region of the elongate monocrystalline nanostructure. In embodiments of the present invention, the control electrode structure may cover more than the channel region, e.g. there may be an overlap with the first and/or second main electrode region.

The Tunnel Field Effect Transistor (NW-TFET) of some embodiments of the present invention further comprises an electrical contact on each of the first main electrode region and the second main electrode region, e.g. the source region and drain region or vice versa. The electrical contact on each of the first and second main electrode regions may be made of a conductive material which is selected from at least one of a silicide containing structure (NiSi, CoSi₂, TiSi₂, ...), a germanide containing structure, a metal containing structure, poly silicon or a combination thereof. In particular embodiments said electrical contact on each of the source region and drain region is a combination of a metal with a silicide.

The first semiconductor material in the NW-TFET of the present invention may be selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. In particular embodiments the first semiconductor material in NW-TFET of the present invention is silicon.

The second material in the NW-TFET of the present invention may be a second semiconductor material which has a lattice constant which is different from the lattice constant of the first semiconductor material of the NW-TFET. In particular embodiments said second semiconductor material is selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. In particular embodiments the second semiconductor material in NW-TFET of the present invention is germanium or Si₁₋ₓGeₓ with x>0.5. In particular embodiments the second semiconductor material in NW-TFET of the present invention has a smaller bandgap and/or a different electron affinity than the first semiconductor material. In particular embodiments of the present invention the second semiconductor material has a smaller electron affinity than the first semiconductor material when its conductivity type is p-type. In alternative embodiments the second semiconductor material has a higher electron affinity than the first semiconductor material when its conductivity type is n-type.

In an alternative embodiment, said second main electrode region can be made of a metal such as Al, W, Ta, Ti, Ru, Pd, Rh, Re, Pt, and alloys thereof, a silicide, a germanide, a metal-nitride such as TaN and TiN, a conductive oxide such as RuO₂ and ReO₂, a silicided metal such as CoSi₂, NiSi₂, a metal germanide and/or alloys and mixtures thereof.

The Tunnel Field Effect Transistor (NW-TFET) comprises a control electrode structure, said control electrode structure comprising a control electrode dielectric, e.g. gate oxide, situated onto the channel region of the NW-TFET and a control electrode contact situated on top of the control electrode dielectric, e.g. gate oxide. The control electrode dielectric may be selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. In particular embodiments, the control electrode oxide, e.g. gate oxide, is a high-k oxide such as hafnium oxide. The thickness of the control electrode dielectric may be in the range of 0.5 nm to 20 nm. The control electrode contact may be made of a conductive material and is selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE). The control electrode contact is chosen such that a particular control electrode workfunction is obtained specifically for the chosen elongate monocrystalline nanostructure material, e.g. nanowire material, (first and second semiconductor material), control electrode dielectric and control electrode dielectric thickness. In particular embodiments the control electrode structure (comprising the control electrode contact and control electrode dielectric) of the NW-TFET completely covers the channel region of the elongate monocrystalline nanostructure, e.g. nanowire.

The diameter of the NW, perpendicular to its longitudinal axis, used in the NW-TFET of some embodiments of the present invention may be in the range of 1nm up to 500 nm, for example the diameter of the NW used in the NW-TFET of embodiments of the present invention is between 2 and 200 nm.

The length of the NW, along its longitudinal axis used in the NW-TFET of some embodiments of the present invention may be in the range of 5 nm and 2 µm, for example the length of the NW used in the NW-TFET of embodiments of the present invention is between 10 nm and 1 µm.

The length of the second main electrode region in the NW-TFET of some embodiments of the present invention may be in the range of 1 nm and 500 nm, for example the length of the heterosection in the NW-TFET of embodiments of the present invention is between 2 nm and 20 nm.

The length of the channel region in the NW-TFET of some embodiments of the present invention may be in the range of 1 nm and 1000 nm, for example the length of the channel region in the NW-TFET of embodiments of the present invention is between 1 nm and 100 nm.

The doping level of the first and second main electrode region, e.g. source region and drain region, in the NW-TFET of some embodiments of the present invention may be in the range of 10¹⁸/cc to 10²¹/cc, for example the doping level of the source region and drain region in the NW-TFET is in the range of 10¹⁹/cc to 5x10²⁰/cc.

The doping level of the channel region in the NW-TFET of the present invention is in the range of undoped up to 10¹⁶/cc, for example the doping level of the channel region in the NW-TFET is in the range of undoped up to 5x10¹⁴/cc.

Furthermore a method for manufacturing a NW-TFET semiconductor device according to claim 25 is disclosed.

Further steps of some embodiments of the method can involve one or more of:
- forming a first main electrode contact to the first main electrode region of the elongate monocrystalline nanostructure
- depositing on the side walls of the elongate monocrystalline nanostructure a control electrode dielectric, e.g. gate oxide,
- depositing on top of the control electrode dielectric a control electrode contact, and
- forming a second main electrode contact on top of the second main electrode region of the elongate monocrystalline nanostructure.

In a particular embodiment, the substrate used for manufacturing a NW-TFET is a Si wafer.

In embodiments of the present invention, said first semiconductor material is selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. In a particular embodiment said first semiconductor material is silicon.

In a particular embodiment, said second main electrode region is made of a second semiconductor material, whereby said second semiconductor material is such that it has a different lattice constant from the first semiconductor material of the elongate monocrystalline nanostructure, e.g. nanowire.

In embodiments of the present invention, said second semiconductor material is selected from at least one of the group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. The second semiconductor material may have a smaller bandgap and/or a different electron affinity than the first semiconductor material. In particular embodiments, said second semiconductor material is germanium or Si₁₋ₓGeₓ with x>0.5.

Alternatively, said second main electrode region can be made of metals (Al, W, Ta, Ti, Ru, Pd, Rh, Re, Pt, and alloys thereof), silicides, germanides, metal-nitrides such as TaN and TiN, conductive oxides such as RuO₂ and ReO₂, silicided metals such as CoSi₂, NiSi₂, metal germanides and alloys and mixtures thereof.

In embodiments of the present invention the diameter of the elongate monocrystalline nanostructure, e.g. nanowire, is between 1 and 500 nm. In particular embodiments, the diameter of the elongate monocrystalline nanostructure, e.g. nanowire, is between 2 and 200 nm.

In embodiments of the present invention, the length of the elongate monocrystalline nanostructure, e.g. nanowire, is between 5 nm and 2 µm. In particular embodiments, the length of the elongate monocrystalline nanostructure, e.g. nanowire, is between 10 nm and 1 µm.

In embodiments of the present invention, the control electrode dielectric is selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. In particular embodiments the control electrode oxide is a high-k oxide such as hafnium oxide.

In embodiments of the present invention, the control electrode contact is made of a conductive material and is selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. In particular embodiments the control electrode contact is made of a metal of which the workfunction has been engineered specifically for the chosen elongate monocrystalline nanostructure material, e.g. nanowire material (first and second semiconductor material).

In embodiments of the invention the first and second main electrode contacts are made from a conductive material which is selected from at least one of a silicide containing structure (NiSi, CoSi₂, TiSi₂, ...), a germanide containing structure, a metal containing structure, poly silicon or a combination thereof. In a particular embodiment said first and second main electrode contact is a combination of a metal with a silicide.

In embodiments of the present invention the length of said second main electrode region is in the range of 1 nm up to 500 nm.

In embodiments of the present invention the length of said channel region is in the range of 1 nm to 1000 nm. In particular embodiments the length of said channel region is in the range of 1 nm to 100 nm.

In embodiments of the present invention the thickness of the control electrode dielectric is in the range of 0.5 nm to 20 nm.

In embodiments of the present invention the doping level of the first and second main electrode regions is in the range of 10¹⁸/cc to 10²¹/cc. In particular embodiments the doping level of the first and second main electrode regions is in the range of 10¹⁹/cc to 5x10²⁰/cc.

According to the present invention the doping level of the channel region is in the range of undoped up to 10¹⁶/cc doping. In particular embodiments the doping level of the channel region is in the range of undoped up to 10¹⁴/cc doping.

For the application in tunnel field-effect-transistor (TFET) devices said elongate monocrystalline nanostructure, i.e. nanowire, forms the channel and source/drain regions of the tunnel field-effect transistor.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### BRIEF DESCRIPTION OF THE DRAWINGS

Exemplary embodiments are illustrated in referenced figures of the drawings. It is intended that the embodiments and figures disclosed herein are to be considered illustrative rather than restrictive.
Figure 1 (PRIOR ART) shows a schematic diagram of a TFET;
Figure 2 illustrates a cross-section of a NW-TFET structure according to an embodiment of the invention;
Figure 3 illustrates a front view of a NW-TFET structure according to an embodiment of the invention;
Figure 4 illustrates a flow diagram of a method for fabricating a NW-TFET of an embodiment of the present invention;
Figure 5A shows a typical energy band diagram of a TFET as shown in Figure 1 (prior art) without and with applied drain-source bias (no gate bias applied). The arrows indicate the tunnel barrier which needs to be crossed.
Figure 5B shows a typical energy band diagram of a TFET as shown in Figure 1 (prior art) without and with applied gate bias (no drain-source bias applied). The arrows indicate the tunnel barrier which needs to be crossed;
Figure 6A shows a TFET structure in accordance with an embodiment of the present invention, used for the simulations of Figure 6B. The structure has a double-gate. The height of the central part (between the oxides) is 100 nm, and the height of the hafnium oxide is 4 nm. The width of the highly p-doped heterosection is 30 nm, the width of the channel section is 100 nm, and the width of the highly n-doped section is 30 nm. The heterosection is made of either Si₀Ge₁ or Ge (2 different embodiments of which corresponding curves are illustrated in Fig. 6B);
Figure 6B illustrates the source-drain current I_{ds} as a function of gate voltage V_{gate} for the TFET structure as shown in Figure 7A with a Si₀Ge₁ heterosection and a Ge heterosection. The voltage V_{ds} = 1 V for all curves.
Figure 7A shows a TFET structure used for the simulations of Figure 7B. The structure has a double-gate. The height of the central part (between the oxides) is 60 nm, and the height of the hafnium oxide is 4 nm. The width of the highly p-doped section is 30 nm, the width of the channel section is 100 nm, and the width of the highly n-doped heterosection is 30 nm. The heterosection is made of either Si or of an artificial material which has all properties of Si but having a larger electron affinity compared to the rest of the nanowire material;
Figure 7B illustrates the source-drain current I_{ds} as a function of gate voltage V_{gate} for the TFET structure as shown in Figure 7A with a Si heterosection and a heterosection made of an artifical material having a larger electron affinity than the rest of the nanowire material. The voltage V_{ds} = 1 V for all curves.

### DETAILED DESCRIPTION OF ILLUSTRATIVE EMBODIMENTS

Embodiments of the present invention will be described with respect to particular embodiments and with reference to certain drawings but the invention is not limited thereto but only by the claims. The drawings described are only schematic and are non-limiting. In the drawings, the size of some of the elements may be exaggerated and not drawn to scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

Whenever reference is made hereinafter to a particular dopant type, this is done for the ease of explanation only and is not intended to limit the invention. It is to be understood that in the examples given herein below, materials and dopant types may be replaced by other suitable materials and dopant types, without changing the invention.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims. In particular, some embodiments of the invention will be described with reference to nanowires, however, this is not intended to limit the invention, and is intended to encompass any example of an elongate monocrystalline nanostructure, which may include nanorods, nanotubes, nanowhiskers and other elongated substantially cylindrical or polygonal structures having a longitudinal axis.

At least some embodiments of the present invention are concerned with the problem of too low ON currents in existing tunnel field effect transistors (TFET). To solve that problem a heterosection made of different material than the main part of the TFET is introduced, said heterosection forming a source (or alternatively drain) region of the TFET. Some embodiments of said TFET can be further characterized as a TFET whereby a heterosection is introduced which forms at least one of the source and drain region and is made of another semiconductor material compared to the semiconductor material of the main part of the TFET. The use of a different material for the main part of the TFET and the heterosection implies that the lattice constant will be different. As an example: if SiGe with a very small Ge content is used for the heterosection, then the lattice constant will be different from the lattice constant of pure Si used for the TFET, but the difference will be very small, such that the SiGe can still be grown on top of Si without an excessive amount of dislocations. A TFET device whereby the channel region and the source/drain region and heterosection are fabricated in a nanowire is further referred to in this application as a NW-TFET.

At least some of the embodiments of the present invention relate to the creation of semiconductor devices and more specifically to the creation of a nanowire Tunnel-Field Effect Transistor (NW-TFET) on a semiconductor substrate. A NW-TFET structure is disclosed whereby the nanowire comprises a first source/drain region made of a first semiconductor material and having a first doping level and first doping composition. The NW-TFET further comprises a second source/drain region referred to as heterosection, said heterosection made of a second semiconductor material and having a second doping level and second doping composition. In embodiments of the present invention a p-doped region is situated at the one end of the nanowire and an n-doped region is situated in the other end of the nanowire. The heterosection is made of a second semiconductor material and is such that it has a different lattice constant from the first semiconductor material of the nanowire, and whereby the resulting NW-TFET has an improved performance compared to the TFET consisting of the semiconductor nanowire without a heterosection. This is because the subthreshold slope can be steeper, which allows reducing the power supply and therefore the power consumption.

In a first embodiment of the invention, NW-TFETs using semiconductive nanowires are disclosed. TFETs using nanowires are known from the prior art (e.g. in US 2005/0274992) whereby said nanowires comprise a n-doped region and a p-doped region which are separated by an undoped channel region, all made of the same semiconductive material. However, none of the prior art devices includes a heterosection acting as the source (or drain) region and whereby the heterosection is such that it has a different lattice constant than the main semiconductor material of the nanowire. This, however, can enable a performance improvement in that low ON currents (less than the International Technology Roadmap for Semiconductors ITRS predictions, which are currently predicting ON currents on the order of 1 mA/µm for a low power operating technology), a typical drawback related to the large resistance of the tunnel barrier in semiconductors with a bandgap of at least 1 eV (e.g. silicon), can be reduced or eliminated.

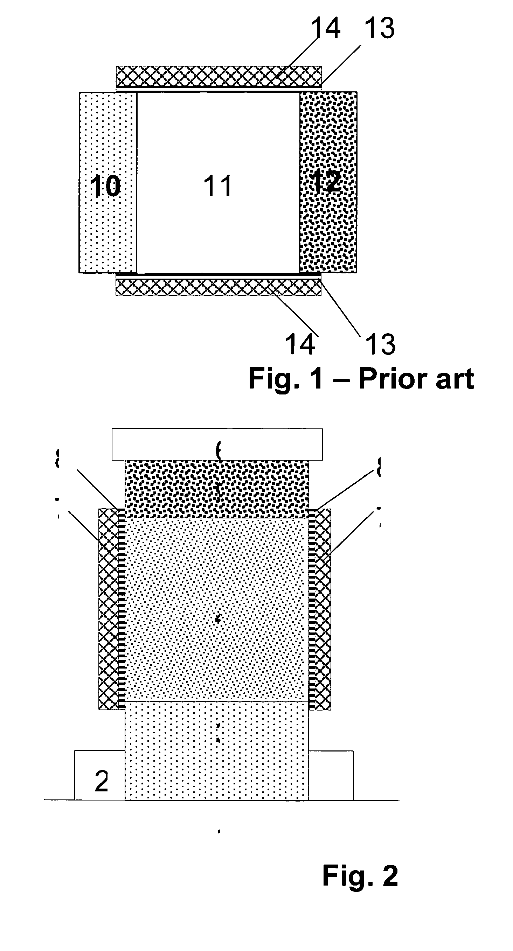

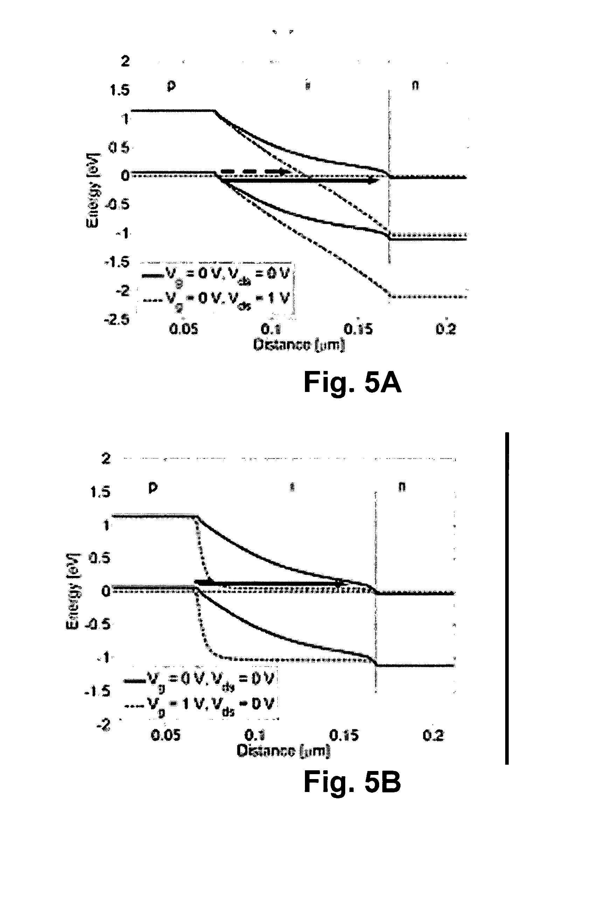

A traditional TFET (without having nanostructures) as shown in Figure 1 and described in the prior art is in fact a p-i-n diode, which is reverse biased and gated. The reverse bias turns the diode off. However, when a sufficiently large reverse bias is applied, quantum mechanical tunneling of electrons occurs from the valence band (in the p-doped section) to the conduction band (in the n-doped section), an effect usually called Zener breakdown. This is shown in Figure 5A, which displays the band diagram of an unbiased and a reverse biased p-i-n diode. The arrow in Figure 5A indicates the tunnel barrier which needs to be crossed. In a TFET, this tunnel effect is desired and represents the on-state of the transistor. The amount of current in the on-state is determined by the tunnel barrier width. The barrier width is the smallest when there is a highly doped region at either side of the tunnel barrier. This requires a highly doped source (or drain) section and a gate voltage such that a large carrier concentration is created in the intrinsic region next to the source (or drain) (see Figure 5B for the effect of a gate bias on the tunnel barrier width). The tunnel barrier width further decreases with decreasing band gap. When comparing this device with a MOSFET, there are a few differences, but many similarities. The MOSFET has either a p-doped source and drain (p-MOSFET) or an n-doped source and drain (n-MOSFET), whereas the TFET has a p-doped source and an n-doped drain, or vice versa. The channel, however, is lowly doped in both devices, and a gate voltage is applied to create a high-mobility channel. Therefore, if the resistance associated with the tunnel barrier can be made sufficiently small, the on-current of a TFET can in principle become comparable to the on-current of a MOSFET (usually the on-current of a TFET is, however, significantly smaller than the on-current of the corresponding MOSFET). The off-currents of a TFET are typically very small, which is due to the presence of the tunnel barrier. The conventional MOSFET on the other hand suffers from short-channel effects which results in source-drain leakage currents, especially as the device size scales down.

A NW-TFET according to the present invention solves or mitigates the problem of low ON currents by introducing a heterosection at the tunnel barrier of the channel, said heterosection being made of a highly doped material and having a bandgap which is smaller than the bandgap of the material used for the other regions of the nanowire and/or having an electron affinity which is different from the electron affinity of the material used for the other regions.

The NW-TFET according to the invention can further be characterized as a TFET having at least one nanowire. Said nanowire comprises the source region, channel region and drain regions of the TFET device whereby one of the source and drain regions is a heterosection and whereby said heterosection is made of a different material than the material used for the other regions of the nanowire. More specifically, in embodiments of the present invention, said heterosection can be or can act as the source region of the nanowire. Alternatively, in other embodiments, said heterosection can be or can act as the drain region of the nanowire.

The nanowire in the NW-TFET of some embodiments of the present invention can be characterized as a semiconductive nanowire wherein the diameter of the nanowire is between 1 and 500 nm and the length of the nanowire is between 5 nm and 2 µm. In particular embodiments the diameter of the nanowire is between 2 nm and 200 nm and the length of the nanowire is between 5 nm and 1 µm, for example between 10 nm and 1 µm.

According to embodiments of the invention, a first semiconductor region, e.g. the source region of the NW-TFET, is made of a first semiconductor material which is highly p doped in case of a n-type NW-TFET, or alternatively, in case of a p-type NW-TFET, said source region is highly n doped. The drain region of the NW-TFET is then made of a heterosection which is made of a second semiconductor material which is highly n doped in case of a n-type NW-TFET, or alternatively, in case of a p-type NW-TFET, said source region is highly p doped. In these embodiments of the present invention the doping level of the source region and of the heterosection acting as drain region is in the range of 10¹⁸/cc to 10²¹/cc. The doping level of the source region and of the heterosection acting as drain region may for example be in the range of 10¹⁹/cc to 5.10²⁰/cc. Said doping can be performed during the growth of the nanowire (e.g. by adding the appropriate doping gases during the growth) or after growth of the nanowire.

According to alternative embodiments of the invention, a first semiconductor region, e.g. the drain region of the NW-TFET, is made of a first semiconductor material which is highly n doped in case of a n-type NW-TFET, or alternatively, in case of a p-type NW-TFET, said source region is highly p doped. The source region of the NW-TFET is then made of a heterosection which is made of a second semiconductor material which is highly p doped in case of a n-type NW-TFET, or alternatively in case of a p-type NW-TFET said source region is highly n doped. In these embodiments of the present invention the doping level of the drain region and of the heterosection acting as source region is in the range of 10¹⁸/cc to 10²¹/cc. The doping level of the drain region and of the heterosection acting as source region may for example be in the range of 10¹⁹/cc to 5.10²⁰/cc. Said doping can be performed during the growth of the nanowire (e.g. by adding the appropriate doping gases during the growth) or after growth of the nanowire.

The channel region of the NW-TFET is also fabricated in the nanowire and is also made of the first semiconductor material. The channel region of the NW-TFET is situated in between the source and drain region, i.e. in between the first semiconductor region and the heterosection. According to the present invention the doping level of the channel region is in the range of undoped up to 10¹⁶/cc doping. The doping level of the channel region may for example be in the range of undoped up to 10¹⁴/cc doping. Said doping can be performed during the growth of the nanowire (e.g. by adding the appropriate doping gases during the growth) or after growth of the nanowire.

The first semiconductor material used to fabricate at least one of the source/drain region and channel region of the nanowire is selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. In particular embodiments said first semiconductor material is silicon.

The length of the channel region may be in the range of 1 nm to 1000 nm, for example in the range of 1 nm to 100 nm.

The heterosection may be made of a second semiconductor material whereby said second semiconductor material is such that it has a different lattice constant from the first semiconductor material of the nanowire. Said second semiconductor material is highly doped and is selected from at least one of the group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. In particular embodiments said second semiconductor material is germanium or Si₁₋ₓGeₓ with x>0.5.

Alternatively, said heterosection can be made of metals (Al, W, Ta, Ti, Ru, Pd, Rh, Re, Pt, and alloys thereof), silicides, germanides, metal-nitrides such as TaN and TiN, conductive oxides such as RuO₂ and ReO₂, silicided metals such as CoSi₂, NiSi₂, metal germanides and alloys and mixtures thereof.

The length of the heterosection may be in the range of 1 nm up to 500 nm.

Onto the sidewalls of the nanowire, more specifically onto the sidewalls of the channel region of the nanowire, a gate structure is situated. Said gate structure can comprise a gate oxide (also referred to as gate dielectric) and a gate electrode (also referred to as gate contact). The gate oxide is making direct contact to the channel region of the nanowire; more specifically said gate oxide completely covers the outer sidewalls of the channel region. To ensure such a complete coverage, a small overlap of the gate oxide with the highly-doped drain and source region is desirable. Onto the gate oxide, a gate contact is deposited, said gate contact is thus situated on top of said gate oxide and may be covering the whole gate oxide. The gate structure, comprising gate oxide and gate contact, as described above can also be referred to as an all around gate structure.

The gate oxide may be selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. In particular embodiments said gate oxide is a high-k oxide such as hafnium oxide. The thickness of the gate oxide may be in the range of 0.5 nm to 20 nm.

The gate contact may be made of a conductive material and may be selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. In particular embodiments said gate contact is made of a metal of which the workfunction has been engineered specifically for the chosen nanowire material, the gate oxide material and gate oxide thickness (first and second semiconductor material) in order to get the desired threshold voltage of the T-FET.

The NW-TFET further comprises an electrical contact on each of the source region and drain region (whereby one of the source and drain region is a heterosection). Said electrical contact on each of the source region and drain region is a conductive material which is selected from at least one of a silicide containing structure (NiSi, CoSi₂, TiSi₂,...), a germanide containing structure, a metal containing structure, poly silicon or a combination thereof. In particular embodiments said electrical contact on each of the source region and drain region is a combination of a metal with a silicide.

In integrated circuits, the nanowire tunnel field effect transistor of the invention may be used as either an n-type transistor device or a p-type transistor device.

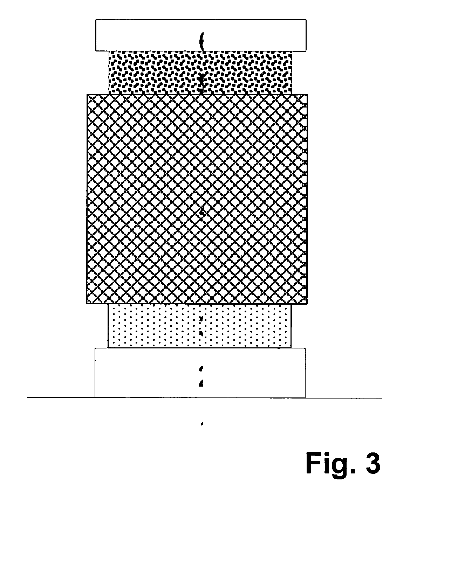

Figure 2 illustrates a cross-section of an NW-TFET structure according to an embodiment of the invention and Figure 3 illustrates a front view of the NW-TFET structure according to an embodiment of the invention.

The NW TFET illustrated comprises, on a substrate 1, a nanostructure comprising a first semiconductor region 3, which can act as a source or drain region, a channel region 4, and a heterosection 9, which can act as a drain or source region, respectively. A gate oxide 8 and a gate electrode 7 are provided against a sidewall of the nanostructure.

In the example illustrated, the heterosection 9 can be partly covered by the gate structure 7, 8 and partially outside of the gate structure 7, 8 depending on the length of the heterosection 9 and of the gate structure 7, 8.

In a second aspect of the invention, a method is provided for the fabrication of a nanowire Tunnel Field Effect transistor. Hereinafter, the method according to an embodiment of the invention will be illustrated for a device according to an embodiment, e.g. for a n-type NW-TFET comprising at least one vertical nanowire as shown in Figure 2 (cross section) and Figure 3 (front view). It has to be understood that this is not limiting the invention and that the method may also be applied to create a p-type NW-TFET comprising at least one vertical nanowire.

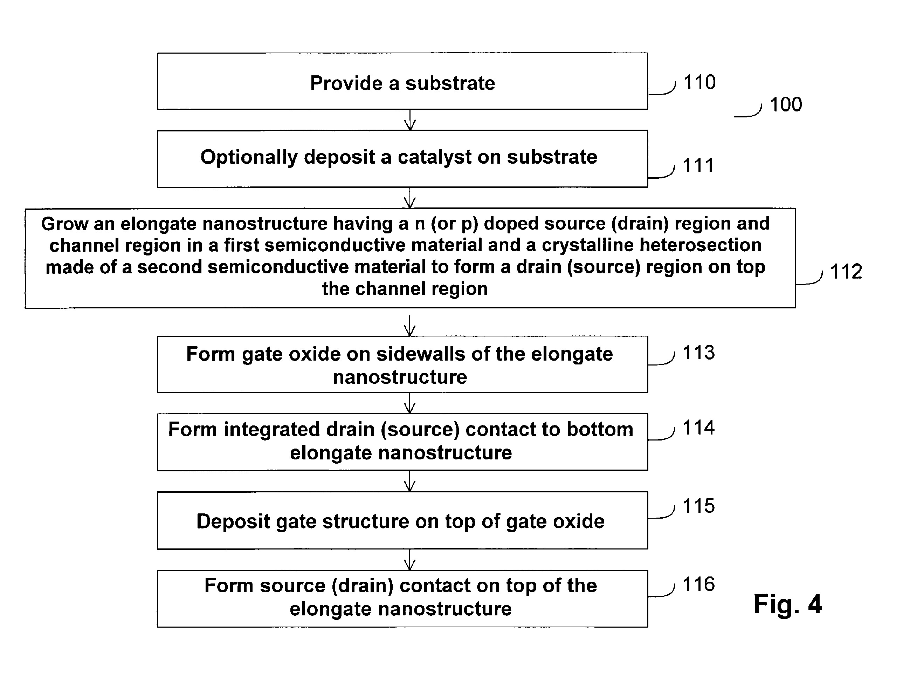

An embodiment of a processing method is schematically illustrated in a flowchart 100 shown in Figure 4 and will be described in detail below. It has, however, to be understood that this is only an example of a suitable method for forming a device according to the invention and that the sequence of the process steps as described hereinafter is not limiting the invention. The process steps are discussed with respect to nanowires, but it is to be understood that also other elongate nanostructures may be formed or used in forming devices in accordance with embodiments of the present invention.

In a first step 110, a substrate 1 is provided. Said substrate 1 may be a semiconductor substrate such as a silicon substrate or a silicon on insulator (SOI) substrate but any other suitable substrate can be used as well such as, for example, glass, ceramics, etc. If needed a catalyst can be deposited onto the substrate (111); the requirement of catalyst particles depends on the technique used to form the nanowire.

In a next step 112, a nanowire is grown, e.g. by means of a VLS (Vapor-Liquid-Solid) process, but also any other suitable technique known by a person skilled in the art may be used to form the nanowires according to the invention. For example, the nanowire may be grown using techniques such as, for example, CVD (Chemical Vapor Deposition), MOCVD (Metal Organic Chemical Vapor Deposition), or PECVD (plasma enhanced chemical vapor deposition) processes. Alternatively, also PLD (Pulsed Laser Deposition), ECD (Electrochemical Deposition), e-beam or MBE (Molecular Beam Epitaxy) processes may be used to grow the nanowires.

During growth of the nanowire, different regions need to be created to form the drain region, the channel region and the source region of the nanowire. The different regions in the nanowire can be doped during the growth process to obtain a n-type or p-type region. Alternatively, the doping of the nanowire may be performed after growth of the nanowire by means of an additional doping step. The doping in one specific region, e.g. source region/ drain region is uniform in particular embodiments, but may also have a nonuniform doping profile.

During growth of the nanowire, first a drain region 3 (or alternatively a source region) is created. Said drain region 3 is made of a first semiconductor material which is highly doped with a dopant of a first conductivity type e.g. n doped in case of a n-type NW-TFET, or alternatively in case of a p-type NW-TFET said drain region is highly p doped. The doping level of the source region may be in the range of 10¹⁸/cc to 10²¹/cc, for example the doping level of the source region is in the range of 10¹⁹/cc to 5.10²⁰/cc.

Subsequently, the channel region of the NW-TFET is formed in the nanowire. Said channel region may be made of the first semiconductor material, although other suitable/compatible materials can be used. The doping level of the channel region is in the range of undoped up to 10¹⁶/cc doping, for example the doping level of the channel region is in the range of undoped up to 10¹⁴/cc doping.

Next, a heterosection 9 is formed onto the channel region 4, said heterosection adapted for acting as the source region of the NW-TFET (or alternatively as the drain region if region 3 is a source region) . The heterosection 9 is made of a second semiconductor material which is such that it has a different lattice constant compared to the first semiconductor material used to form the main part of the nanowire. Said second semiconductor material is highly doped with a second conductivity type. Said second semiconductor material may be selected from at least one of the group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof. In particular embodiments said second semiconductor material is germanium or Si₁₋ₓGeₓ with x>0.5. The doping level of the heterosection is such that the heterosection can function as a source (or alternatively drain) region and is preferably in the range of 10¹⁸/cc to 10²¹/cc, for example the doping level of the heterosection is more preferably in the range of 10¹⁹/cc to 5x10²⁰/cc.

Alternatively, said heterosection can be made of metals (Al, W, Ta, Ti, Ru, Pd, Rh, Re, Pt, and alloys thereof), silicides, germanides, metal-nitrides such as TaN and TiN, conductive oxides such as RuO₂ and ReO₂, silicided metals such as CoSi₂, NiSi₂, metal germanides and alloys and mixtures thereof.

In a next step 113, a gate oxide is formed onto the sidewalls of the nanowire, more specifically onto at least the sidewalls of the channel region of the nanowire. Said gate structure comprises a gate oxide 8 (also referred to as gate dielectric). First the gate oxide 8 is formed and deposited directly onto at least the channel region 4 of the nanowire 113. Said gate oxide 8 may completely cover the outer sidewalls of the channel region 4. To obtain a complete coverage of the channel region, a small overlap of the gate oxide with the highly-doped drain and/or source region is desirable. The gate oxide can be restricted to part of the nanowire (e.g. channel region and optionally a small overlap with drain and/or source region), by means of a sacrificial layer, which is etched away before the oxide deposition (this implies that e.g. other materials are deposited onto the wafer after nanowire growth, such that the nanowire is embedded in other materials). This should be done in such a way that a sacrificial layer lines up with the channel region of the nanowire. After removal of the sacrificial material, a dielectric, e.g. an oxide, can be deposited onto at least the nanowire channel region.

In a next step an integrated drain contact 2 is formed on the bottom of the nanowire, contacting the drain region 3, step 114.

A gate contact (electrode) 7 is formed onto the gate dielectric 8, step 115. Said gate contact 7 is deposited on top of said gate dielectric 8, e.g. gate oxide, and can cover the whole gate oxide 8.

The gate dielectric 8 may be selected from at least one of silicon based oxide (e.g. silicon dioxide, silicon oxy nitride) aluminium oxide, high-k oxides (oxides, nitrided oxides), silicates and nitrided silicates of transition metals such as Hf, Ta, Ti, Nb, V, Y, Zr. In particular embodiments said gate oxide is a high-k oxide such as hafnium oxide. The thickness of the gate oxide may be in the range of 0.5 nm to 20 nm.

The gate contact 7 may be made of a conductive material and may be selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. In particular embodiments said gate contact is made of a metal of which the workfunction has been engineered specifically for the chosen nanowire material, the gate oxide material and gate oxide thickness.

Finally, step 116, an electrical contact 6 is formed on the heterosection 9 (acting as source region) situated on top of the nanowire. Said electrical contact 6 may be made from a conductive material which is selected from at least one of a silicide containing structure (NiSi, CoSi₂, TiSi₂,...), a germanide containing structure, a metal containing structure, poly silicon or a combination thereof. In particular embodiments said electrical contact is a combination of a metal with a silicide.

In case the nanowire is not doped during the growth process, an extra doping step may be advantageous. For example, implantation of dopant elements followed by activation of the dopant elements by e.g. annealing can be applied to achieve n-type or p-type region in the nanowire. Alternatively, a layer, which is also referred to as dopant layer and which comprises dopant elements can be deposited or a dopant metal can be selectively deposited, e.g. with electrochemical deposition, onto the nanowire regions (not shown). An anneal step may then be applied so as to incorporate the dopant into the nanowire region, resulting in an n-type or p-type region.

The whole processing sequence to obtain a NW-TFET, in the example shown in Figure 2 for a n-type NW-TFET, as described in the previous steps can be repeated to build a second NW-TFET structure on top of the existing NW-TFET structure starting on the drain contact 6. In case the first NW-TFET structure is a n-type NW-TFET structure, the second structure may for example be a p-type NW-TFET structure.

### EXAMPLES

### Example 1: Simulations with device simulator MEDICI to illustrate the effect of electron affinity on a (silicon) n-type NW-TFET with a highly p-doped Ge heterosection.

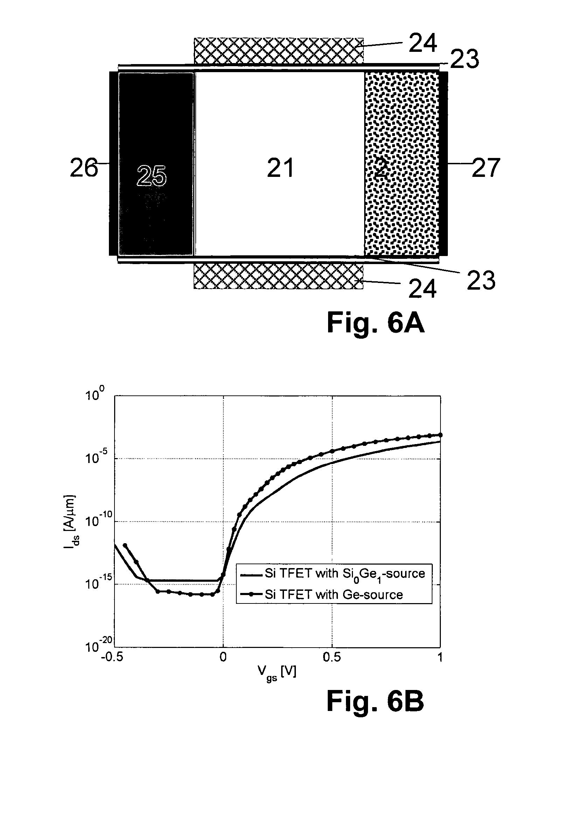

The simulations are performed with device simulator "MEDICI" to illustrate the effect of electron affinity on a (silicon) n-type NW-TFET with a highly p-doped Ge heterosection. The NW-TFET used for the simulation is shown in Figure 6A. The NW-TFET structure has a double-gate, i.e. a gate structure 23, 24 is provided at either side of the channel region 21. The height of the central part 21 (between the oxides) is 100 nm, and the height of the hafnium oxide 23 is 4 nm. The width of the highly p-doped heterosection 25 which forms the source region is 30 nm, the width of the channel region 21 is 60 nm, and the width of the highly n-doped drain 22 section is 30 nm. The heterosection 25 is made of either Si₀Ge₁ or Ge. The definition of Si₀Ge₁ in MEDICI is: an artificial material with the bandgap of Ge but with the electron affinity of Si. The doping concentrations and dopant types in the NW-TFET used to perform the simulations are summarized in Table 1.

**Table 1: Doping concentrations and dopant type in the NW-TFET used to perform the simulations.**

| Nanowire region | Dopant type/ concentration | Semiconductor material |
|---|---|---|
| Heterosection source region | p-type, 10²⁰/cc | Ge or Si₀Ge₁ |
| Channel region | n-type, 10¹³/cc | Si |
| Drain region | n-type, 10²⁰/cc | Si |

The electrical characteristics of the NW-TFET structure as shown in Figure 6A are presented in Figure 6B. The Ge-curve has been shifted to the right in order for the onset of tunneling to occur at the same gate voltage (V_{gs} = 0 V) as the Si₀Ge₁-curve, such that a better comparison of both curves is possible. It can be observed that for the NW-TFET with the Ge heterosection, a higher on-current and a steeper subthreshold slope are achieved than for the NW-TFET with the Si₀Ge₁ heterosection. This is due to the fact that the tunnel barrier width decreases because the electron affinity of Ge in the heterosection source region is smaller than the electron affinity of Si in the channel region, whereas for Si₀Ge₁ the electron affinity is the same as for Si. The simulations of Figure 6B therefore illustrate that not only the bandgap of the material is may be taken into account, but also the electron affinity. The simulations further illustrate that in case of a p-doped heterosection which forms part of the source region of an n-type NW-TFET, the electron affinity of the heterosection is, for example, smaller than the electron affinity of the main part of the nanowire.

### Example 2: Simulations with device simulator MEDICI to illustrate the effect of electron affinity on a (silicon) p-type NW-TFET with a highly n-doped heterosection.

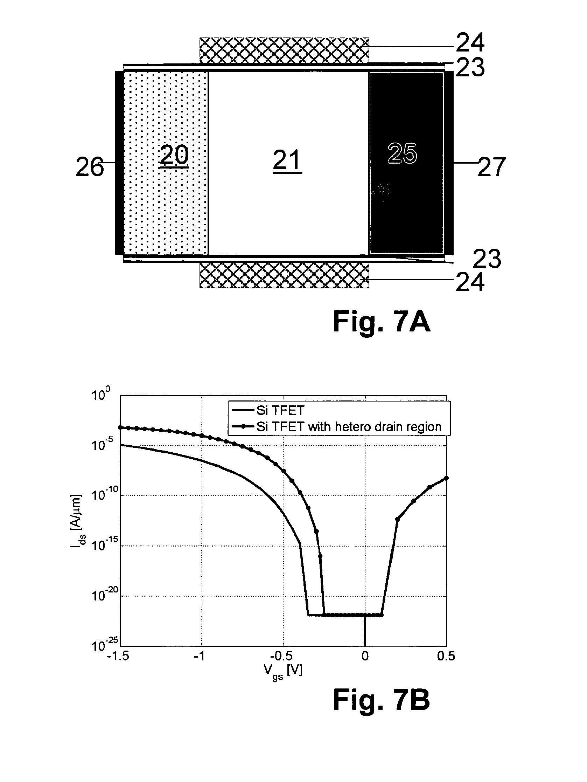

The simulations are performed with device simulator "MEDICI" to illustrate the effect of electron affinity on a (silicon) p-type NW-TFET with a highly n-doped heterosection. The NW-TFET used for the simulation is shown in Figure 7A. The NW-TFET structure has a double-gate, i.e. a gate structure 23, 24 is provided at either side of the channel region 21. The height of the central part 21 (between the oxides) is 100 nm, and the height of the hafnium gate 23 oxide is 4 nm. The width of the highly p-doped source region 20 is 30 nm, the width of the channel region 21 is 100 nm, and the width of the highly n-doped heterosection 25 which forms the drain region is 30 nm. The heterosection 25 is made of either Si or of an artificial material X which has all properties of Si except for a larger electron affinity (E_{aff,X} = 4.69 eV, instead of the correct value of E_{aff,Si} = 4.17 eV). The doping concentrations and dopant type in the NW-TFET used to perform the simulations are summarized in Table 2.

**Table 2: Doping concentrations and dopant type in the NW-TFET used to perform the simulations.**

| **Nanowire region** | **Dopant type/ concentration** | **Semiconductor material** |
|---|---|---|
| Source region | p-type, 10¹⁰/cc | Si |
| Channel region | n-type, 10¹³/cc | Si |
| Heterosection drain region | n-type, 10²⁰/cc | Si or artificial material X |

The electrical characteristics of the NW-TFET structure as shown in Figure 7A are presented in Figure 7B. It can be observed that for the NW-TFET with the artifical X heterosection, a higher on-current and a steeper subthreshold slope are achieved than for the all-Si NW-TFET. This is due to the fact that the tunnel barrier width decreases because the electron affinity of the artifical material X in the heterosection drain region is larger than the electron affinity of Si in the channel region. The simulations of Figure 7B therefore illustrate that even when the bandgap of the material of the heterosection is the same as the bandgap of the main part of the nanowire, the on-current of the NW-TFET can be improved with a heterosection with an appropriate electron affinity. The simulations further illustrate that in case of an n-doped heterosection which forms part of the drain region of a p-type NW-TFET, the electron affinity of the heterosection is for example larger than the electron affinity of the main part of the nanowire.

As has been described above, tunnel field-effect transistors (TFETs) are regarded as successors of metal-oxide semiconductor field-effect transistors (MOSFETs), but silicon-based TFETs typically suffer from low on-currents, a drawback related to the large resistance of the tunnel barrier. To achieve higher on-currents a TFET with a heterosection, e.g. a germanium (Ge) heterosection, acting as source (drain) region is used. A nanowire-based structure with a heterosection is introduced such that the lattice mismatch between the first semiconductor material, e.g. silicon, and the heterosection material, e.g. germanium, does not result in a highly defective interface. A dynamic power reduction as well as a static power reduction can result, compared to conventional MOSFET configurations. Multiple layers of logic can therefore be envisioned with these nanowire Si/Ge TFETs resulting in ultra-high on-chip transistor densities.

## Claims

1. A nanowire tunnel Field Effect Transistor (TFET) semiconductor device comprising at least one elongate monocrystalline nanostructure (NW-TFET),
said elongate monocrystalline nanostructure being a nanowire structure and comprising
a first main electrode region (3; 22) made of first semiconductor material highly doped with dopants of a first conductivity type,
a second main electrode region (9; 25) made of a second material different from the first semiconductor material and highly doped with dopants of a second conductivity type different from the first conductivity type, and
a channel region (4; 21) in between the first main electrode region (3; 22) and the second main electrode region (9; 25), the channel region (4; 21) being of the first semiconductor material and being lowly doped, whereby the doping level of the channel region (4, 21) is in the range of undoped up to 10¹⁶/cc, and wherein the second main electrode region is a hetero-section of said nanowire structure which interfaces said channel region by means of an interface, the material of the heterosection and / or the cross-section of the nanowire being such that said interface is substantially defect-free;
the tunnel Field Effect Transistor furthermore comprising a control electrode structure (8, 7; 23, 24) on the channel region (4; 21).

2. The Tunnel Field Effect Transistor (NW-TFET) according to claim 1, wherein the control electrode structure (8, 7; 23, 24) completely covers the channel region (4; 21) of the elongate monocrystalline nanostructure.

3. The Tunnel Field Effect Transistor (NW-TFET) according to any of the previous claims further comprising an electrical contact (2, 6) on each of the first main electrode region (3; 22) and the second main electrode region (9; 25).

4. The Tunnel Field Effect Transistor (NW-TFET) according to any of the previous claims whereby said first semiconductor material is selected from at least one of group IV materials and binary compounds thereof, or group III/V materials and binary, tertiary and quaternary compounds thereof or group II/VI materials and binary, tertiary and quaternary compounds thereof.

5. The Tunnel Field Effect Transistor (NW-TFET) according to any of the previous claims whereby said first semiconductor material comprises silicon.

6. The Tunnel Field Effect Transistor (NW-TFET) according to any of the previous claims whereby said second material is a second semiconductor material which has a different lattice constant from the first semiconductor material of the elongate monocrystalline nanostructure.

7. The Tunnel Field Effect Transistor (NW-TFET) according to any of the previous claims whereby said second material is a second semiconductor material selected from at least one of the group IV materials and binary compounds thereof, or group III/V materials and binary, tertiary and quaternary compounds thereof or group II/VI materials and binary, tertiary and quaternary compounds thereof.

8. The Tunnel Field Effect Transistor (NW-TFET) according to any of the previous claims whereby said second material is a semiconductor material comprising germanium or Si₁₋ₓGeₓ with x>0.5.

9. The Tunnel Field Effect Transistor (NW-TFET) according to any of the previous claims whereby said second material is a second semiconductor material having a smaller bandgap than the first semiconductor material.

10. The Tunnel Field Effect Transistor (NW-TFET) according to any of the previous claims whereby said second material has an electron affinity which is different from the electron affinity of the first semiconductor material.

11. The Tunnel Field Effect Transistor (NW-TFET) according to any of the previous claims whereby said second material is a second semiconductor material, whereby the second semiconductor material is selected to have a smaller electron affinity than the first semiconductor material when its conductivity type is p-type or whereby said second semiconductor material is selected to have a higher electron affinity than the first semiconductor material when its conductivity type is n-type.

12. The Tunnel Field Effect Transistor (NW-TFET) according to claims 1 to 5 whereby said second material is selected from at least one of the group of metals (Al, W, Ta, Ti, Ru, Pd, Rh, Re, Pt, and alloys thereof), silicides, germanides, metal-nitrides, conductive oxides, silicided metals , metal germanides and alloys and mixtures thereof.

13. The Tunnel Field Effect Transistor (NW-TFET) according to any of the previous claims, wherein the diameter of the at least one elongate monocrystalline nanostructure is between 1 and 500 nm, preferably between 2 and 200 nm.

14. The Tunnel Field Effect Transistor (NW-TFET) according to any of the previous claims, wherein the length of the at least one elongate monocrystalline nanostructure is between 5 nm and 2 µm, preferably between 10 nm and 1 µm.

15. The Tunnel Field Effect Transistor (NW-TFET) according to any of the previous claims whereby said control electrode structure (8,7; 23,24) comprises a control electrode dielectric (8, 23) selected from at least one of silicon based oxide, aluminium oxide, high-k oxides, silicates and nitrided silicates of transition metals.

16. The Tunnel Field Effect Transistor (NW-TFET) according to claim 15 whereby said control electrode dielectric (8, 23) is hafnium oxide.

17. The Tunnel Field Effect Transistor (NW-TFET) according to any of claims 15 or 16, whereby said control electrode structure (8, 7; 23,24) comprises a control electrode contact made of a conductive material selected from at least one of poly silicon, poly germanium, a metal or a metal alloy, metal-nitrides, metal-silicon nitrides, conductive oxides, fully silicided metals, fully germanided metals, workfunction tunable metals, engineered materials to obtain a particular gate workfunction.

18. The Tunnel Field Effect Transistor (NW-TFET) according to claim 17, whereby said control electrode contact is made of a metal of which the workfunction has been engineered specifically for the first semiconductor material, second material, control electrode dielectric and control electrode dielectric thickness.

19. The Tunnel Field Effect Transistor (NW-TFET) according to claim 3 or a claim dependent on claim 3, whereby said electrical contact on each of the first main electrode region (3; 22) and the second main electrode region (9; 25) is made of a conductive material which is selected from at least one of a silicide containing structure, a germanide containing structure, a metal containing structure, poly silicon or a combination thereof.

20. The Tunnel Field Effect Transistor (NW-TFET) according to claim 19, whereby said electrical contact is made of a combination of a metal with a silicide.

21. The Tunnel Field Effect Transistor (NW-TFET) according to any of the previous claims whereby the length of said channel region (4, 21) is in the range of 1 nm to 1000 nm, preferably in the range of 1 nm to 100 nm.

22. The Tunnel Field Effect Transistor (NW-TFET) according to any of the previous claims whereby the thickness of the gate dielectric (8) is in the range of 0.5 nm to 20 nm.

23. Tunnel Field Effect Transistor (NW-TFET) according to any of the previous claims whereby the doping level of the first main electrode region (3; 22) and the second main electrode region (9; 25) is in the range of 10¹⁸/cc to 10²¹/cc, preferably in the range of 10¹⁹/cc to 5x10²⁰/cc.

24. The Tunnel Field Effect Transistor (NW-TFET) according to any of the previous claims whereby the doping level of the channel region (4, 21) is in the range of undoped up to 10¹⁴/cc doping.

25. A method for manufacturing a elongate monocrystalline nanowire Tunnel Field Effect Transistor (NW-TFET) semiconductor device comprising the steps of:
- providing a substrate (1) lying in a plane,
- growing an elongate monocrystalline nanowire structure, said elongate monocrystalline nanostructure having a first main electrode region (3; 22) of a first semiconductor material, a second main electrode region (9; 25) of a second material different from the first semiconductor material, and a channel region (4, 21) in between the first main electrode region (3; 22) and the second main electrode region (9; 25), the channel region (4; 21) being of the first semiconductor material, wherein the second main electrode region is a hetero-section of said nanowire structure which interfaces said channel region by means of an interface the material of the heterosection and / or the cross-section of the nanowire being such that said interface is substantially defect-free;
- selectively doping said first main electrode region (3; 22) to a high doping level with dopants of a first conductivity type, selectively doping said channel region (4; 21) with a doping level being in the range of undoped up to 10¹⁶/cc, and selectively doping said second main electrode region (9; 25) to a high doping level with dopants of a second conductivity type, the first conductivity type being different from the second conductivity type, and
- providing a control electrode structure (8, 7; 23, 24) on the channel region.

26. The method of claim 25 whereby said substrate (1) is a Si wafer.

27. Use of the method of any of claims 25 or 26 for forming an elongate monocrystalline nanostructure Tunnel Field Effect Transistor (NW-TFET) semiconductor device according to any of claims 1 to 24.

## Patentansprüche

1. Nanodraht-Tunnel-Feldeffekttransistor- (TFET) Halbleitervorrichtung, umfassend zumindest eine längliche monokristalline Nanostruktur (NW-TFET), wobei die längliche monokristalline Nanostruktur eine Nanodrahtstruktur ist und umfasst:
eine erste Hauptelektrodenregion (3; 22), die aus einem ersten Halbleitermaterial besteht, das hoch mit Dotierungsmitteln eines ersten Leitfähigkeitstyps dotiert ist,
eine zweite Hauptelektrodenregion (9; 25), die aus einem zweiten Material besteht, das sich vom ersten Halbleitermaterial unterscheidet und hoch mit Dotierungsmitteln eines zweiten Leitfähigkeitstyps dotiert ist, der sich vom ersten Leitfähigkeitstyp unterscheidet, und
eine Kanalregion (4; 21) zwischen der ersten Hauptelektrodenregion (3; 22) und der zweiten Hauptelektrodenregion (9; 25), wobei die Kanalregion (4; 21) aus dem ersten Halbleitermaterial besteht und gering dotiert ist, wobei das Dotierungsniveau der Kanalregion (4; 21) im Bereich von undotiert bis 10¹⁶/cc reicht und wobei die zweite Hauptelektrodenregion ein Heteroabschnitt der Nanodrahtstruktur ist, der durch eine Grenzfläche an die Kanalregion angrenzt, wobei das Material des Heteroabschnitts und/oder der Querschnitt des Nanodrahts derart sind, dass die Grenzfläche im Wesentlichen frei von Defekten ist;
wobei der Tunnel-Feldeffekttransistor ferner eine Steuerelektrodenstruktur (8, 7; 23, 24) auf der Kanalregion (4; 21) umfasst.

2. Tunnel-Feldeffekttransistor (NW-TFET) nach Anspruch 1, wobei die Steuerelektrodenstruktur (8, 7; 23, 24) die Kanalregion (4; 21) der länglichen monokristallinen Nanostruktur vollständig bedeckt.

3. Tunnel-Feldeffekttransistor (NW-TFET) nach einem der vorangehenden Ansprüche, des Weiteren umfassend einen elektrischen Kontakt (2, 6) an jeder der ersten Hauptelektrodenregion (3; 22) und der zweiten Hauptelektrodenregion (9; 25).

4. Tunnel-Feldeffekttransistor (NW-TFET) nach einem der vorangehenden Ansprüche, wobei das erste Halbleitermaterial ausgewählt ist aus zumindest einem der Gruppe von IV-Materialien und binären Verbindungen davon, oder Gruppe III/V-Materialien und binären, tertiären und quaternären Verbindungen davon oder Gruppe II/VI-Materialien und binären, tertiären und quaternären Verbindungen davon.

5. Tunnel-Feldeffekttransistor (NW-TFET) nach einem der vorangehenden Ansprüche, wobei das erste Halbleitermaterial Silizium umfasst.

6. Tunnel-Feldeffekttransistor (NW-TFET) nach einem der vorangehenden Ansprüche, wobei das zweite Material ein zweites Halbleitermaterial ist, das eine andere Gitterkonstante als das erste Halbleitermaterial der länglichen monokristallinen Nanostruktur hat.

7. Tunnel-Feldeffekttransistor (NW-TFET) nach einem der vorangehenden Ansprüche, wobei das zweite Material ein zweites Halbleitermaterial ist, das ausgewählt ist aus zumindest einem der Gruppe von IV-Materialien und binären Verbindungen davon, oder Gruppe III/V-Materialien und binären, tertiären und quaternären Verbindungen davon, oder Gruppe II/VI-Materialien und binären, tertiären und quaternären Verbindungen davon.

8. Tunnel-Feldeffekttransistor (NW-TFET) nach einem der vorangehenden Ansprüche, wobei das zweite Material ein Halbleitermaterial ist, das Germanium oder Si₁₋ₓGeₓ umfasst, wobei x > 0,5.

9. Tunnel-Feldeffekttransistor (NW-TFET) nach einem der vorangehenden Ansprüche, wobei das zweite Material ein zweites Halbleitermaterial mit einer kleineren Bandlücke als das erste Halbleitermaterial ist.

10. Tunnel-Feldeffekttransistor (NW-TFET) nach einem der vorangehenden Ansprüche, wobei das zweite Material eine Elektronenaffinität hat, die sich von der Elektronenaffinität des ersten Halbleitermaterials unterscheidet.

11. Tunnel-Feldeffekttransistor (NW-TFET) nach einem der vorangehenden Ansprüche, wobei das zweite Material ein zweites Halbleitermaterial ist, wobei das zweite Halbleitermaterial so gewählt ist, dass es eine geringere Elektronenaffinität als das erste Halbleitermaterial hat, wenn sein Leitfähigkeitstyp ein p-Typ ist, oder wobei das zweite Halbleitermaterial so gewählt ist, dass es eine höhere Elektronenaffinität als das erste Halbleitermaterial hat, wenn sein Leitfähigkeitstyp ein n-Typ ist.

12. Tunnel-Feldeffekttransistor (NW-TFET) nach Ansprüchen 1 bis 5, wobei das zweite Material ausgewählt ist aus zumindest einem der Gruppe von Metallen (Al, W, Ta, Ti, Ru, Pd, Rh, Re, Pt und Legierungen davon), Siliciden, Germaniden, Metallnitriden, leitenden Oxiden, silicidierten Metallen, Metallgermaniden und Legierungen und Gemischen davon.

13. Tunnel-Feldeffekttransistor (NW-TFET) nach einem der vorangehenden Ansprüche, wobei der Durchmesser der zumindest einen länglichen monokristallinen Nanostruktur zwischen 1 und 500 nm, vorzugsweise zwischen 2 und 200 nm beträgt.

14. Tunnel-Feldeffekttransistor (NW-TFET) nach einem der vorangehenden Ansprüche, wobei die Länge der zumindest einen länglichen monokristallinen Nanostruktur zwischen 5 nm und 2 µm, vorzugsweise zwischen 10 nm und 1 µm beträgt.

15. Tunnel-Feldeffekttransistor (NW-TFET) nach einem der vorangehenden Ansprüche, wobei die Steuerelektrodenstruktur (8, 7; 23, 24) ein Steuerelektrodendielektrikum (8, 23) umfasst, das ausgewählt ist aus zumindest einem von siliziumbasierten Oxid, Aluminiumoxid, Oxiden mit hoher k-Zahl, Silicaten und nitridierten Silicaten von Übergangsmetallen.

16. Tunnel-Feldeffekttransistor (NW-TFET) nach Anspruch 15, wobei das Steuerelektrodendielektrikum (8, 23) Hafniumoxid ist.

17. Tunnel-Feldeffekttransistor (NW-TFET) nach einem der Ansprüche 15 oder 16, wobei die Steuerelektrodenstruktur (8, 7; 23, 24) einen Steuerelektrodenkontakt umfasst, der aus einem leitenden Material besteht, das ausgewählt ist aus zumindest einem von Polysilizium, Polygermanium, einem Metall oder einer Metalllegierung, Metallnitriden, Metall-Siliziumnitriden, leitenden Oxiden, voll silicidierten Metall, voll germanidisierten Metallen, auf die Arbeitsfunktion abstimmbaren Metallen, bearbeiteten Materialien, um eine bestimmte Gate-Arbeitsfunktion zu erhalten.

18. Tunnel-Feldeffekttransistor (NW-TFET) nach Anspruch 17, wobei der Steuerelektrodenkontakt aus einem Metall besteht, dessen Arbeitsfunktion insbesondere für das erste Halbleitermaterial, das zweite Material, das Steuerelektrodendielektrikum und die Dicke des Steuerelektrodendielektrikums bearbeitet wurde.

19. Tunnel-Feldeffekttransistor (NW-TFET) nach Anspruch 3 oder einen Anspruch, der von Anspruch 3 abhängig ist, wobei der elektrische Kontakt an jeder der ersten Hauptelektrodenregion (3; 22) und der zweiten Hauptelektrodenregion (9; 25) aus einem leitenden Material besteht, das ausgewählt ist aus zumindest einem von einer silicidhaltigen Struktur, einer germanidhaltigen Struktur, einer metallhaltigen Struktur, Polysilizium oder einer Kombination davon.

20. Tunnel-Feldeffekttransistor (NW-TFET) nach Anspruch 19, wobei der elektrische Kontakt aus einer Kombination eines Metalls mit einem Silicid besteht.

21. Tunnel-Feldeffekttransistor (NW-TFET) nach einem der vorangehenden Ansprüche, wobei die Länge der Kanalregion (4, 21) im Bereich von 1 nm bis 1000 nm, vorzugsweise im Bereich von 1 nm bis 100 nm liegt.

22. Tunnel-Feldeffekttransistor (NW-TFET) nach einem der vorangehenden Ansprüche, wobei die Dicke des Gate-Dielektrikums (8) im Bereich von 0,5 nm bis 20 nm liegt.

23. Tunnel-Feldeffekttransistor (NW-TFET) nach einem der vorangehenden Ansprüche, wobei das Dotierungsniveau der ersten Hauptelektrodenregion (3; 22) und der zweiten Hauptelektrodenregion (9; 25) im Bereich von 10¹⁸/cc bis 10²¹/cc, vorzugsweise im Bereich von 10¹⁹/cc bis 5x10²⁰/cc liegt.

24. Tunnel-Feldeffekttransistor (NW-TFET) nach einem der vorangehenden Ansprüche, wobei das Dotierungsniveau der Kanalregion (4, 21) im Bereich von undotiert bis 10¹⁴/cc Dotierung liegt.

25. Verfahren zur Herstellung einer länglichen monokristallinen Nanodraht-Tunnel-Feldeffekttransistor- (NW-TFET) Halbleitervorrichtung, umfassend die Schritte:
- Bereitstellen einer Trägerschicht (1), die in einer Ebene liegt,
- Züchten einer länglichen monokristallinen Nanodrahtstruktur, wobei die längliche monokristalline Nanostruktur eine erste Hauptelektrodenregion (3; 22) aus einem ersten Halbleitermaterial, eine zweite Hauptelektrodenregion (9; 25) aus einem zweiten Material, das sich vom ersten Halbleitermaterial unterscheidet, und eine Kanalregion (4; 21) zwischen der ersten Hauptelektrodenregion (3; 22) und der zweiten Hauptelektrodenregion (9; 25) hat, wobei die Kanalregion (4; 21) aus dem ersten Halbleitermaterial besteht, wobei die zweite Hauptelektrodenregion ein Heteroabschnitt der Nanodrahtstruktur ist, der durch eine Grenzfläche an die Kanalregion angrenzt, wobei das Material des Heteroabschnitts und/oder der Querschnitt des Nanodrahts derart sind, dass die Grenzfläche im Wesentlichen frei von Defekten ist;
- selektives Dotieren der ersten Hauptelektrodenregion (3; 22) auf ein hohes Dotierungsniveau mit Dotierungsmitteln eines ersten Leitfähigkeitstyps, selektives Dotieren der Kanalregion (4; 21) mit einem Dotierungsniveau im Bereich von undotiert bis 10¹⁶/cc, und selektives Dotieren der zweiten Hauptelektrodenregion (9; 25) auf ein hohes Dotierungsniveau mit Dotierungsmitteln eines zweiten Leitfähigkeitstyps, wobei sich der erste Leitfähigkeitstyp vom zweiten Leitfähigkeitstyp unterscheidet, und
- Bereitstellen einer Steuerelektrodenstruktur (8, 7; 23, 24) auf der Kanalregion.

26. Verfahren nach Anspruch 25, wobei die Trägerschicht (1) ein Si-Wafer ist.

27. Verwendung des Verfahrens nach Ansprüchen 25 oder 26 zur Bildung einer länglichen monokristallinen Nanostruktur-Tunnel-Feldeffekttransistor- (NW-TFET) Halbleitervorrichtung nach einem der Ansprüche 1 bis 24.

## Revendications

1. Un dispositif semiconducteur de transistor à effet de champs tunnel à nanofil (TFET) comprenant au moins une nanostructure monocristalline allongée (NW-TFET),
ladite nanostructure monocristalline allongée étant une structure de nanofil et comprenant
une première région d'électrode principale (3 ; 22) faite d'un premier matériau semiconducteur fortement dopé avec des dopants d'un premier type de conductivité,
une seconde région d'électrode principale (9 ; 25) faite d'un second matériau différent du premier matériau semiconducteur et fortement dopé avec des dopants d'une second type de conductivité différent du premier type, et
une région de canal (4 ; 21) entre la première région d'électrode principale (3 ; 22) et la seconde région d'électrode principale (9 ; 25), la région de canal (4 ; 21) étant du premier matériau semiconducteur et étant faiblement dopée, dans lequel le niveau de dopage de la région de canal (4, 21) est dans la plage de non dopé jusqu'à 10¹⁶/cc, et dans lequel la seconde région d'électrode principale (9 ; 25) est une hétéro-section de ladite structure de nanofil qui s'interface avec ladite région de canal au moyen d'une interface, le matériau de l'hétérosection et/ou la coupe transversale du nanofil étant telle que ladite interface est sensiblement sans défaut ;
le transistor à effet de champs tunnel comprenant en outre une structure d'électrode de commande (8, 7 ; 23, 24) sur la région de canal (4 ; 21).

2. Le transistor à effet de champs tunnel (NW-TFET) selon la revendication 1, dans lequel la structure d'électrode de commande (8, 7 ; 23, 24) couvre complètement la région de canal (4 ; 21) de la nanostructure monocristalline allongée.

3. Le transistor à effet de champs tunnel (NW-TFET) selon l'une quelconque des revendications précédentes comprenant en outre un contact électrique (2, 6) sur chacune de la première région d'électrode principale (3 ; 22) et de la seconde région d'électrode principale (9 ; 25).

4. Le transistor à effet de champs tunnel (NW-TFET) selon l'une quelconque des revendications précédentes dans lequel ledit premier matériau semiconducteur est sélectionné parmi au moins l'un des matériaux de groupe IV et ses composés binaires, ou des matériaux de groupe III/V et ses composés binaires, tertiaires et quaternaires ou des matériaux de groupe II/IV et ses composés binaires, tertiaires et quaternaires.

5. Le transistor à effet de champs tunnel (NW-TFET) selon l'une quelconque des revendications précédentes dans lequel ledit premier matériau semiconducteur comprend du silicium.

6. Le transistor à effet de champs tunnel (NW-TFET) selon l'une quelconque des revendications précédentes dans lequel ledit second matériau est un second matériau semiconducteur qui a une constante de réseau différente du premier matériau semiconducteur de la nanostructure monocristalline allongée.

7. Le transistor à effet de champs tunnel (NW-TFET) selon l'une quelconque des revendications précédentes dans lequel ledit second matériau est un second matériau semiconducteur sélectionné parmi au moins l'un des matériaux de groupe IV et ses composés binaires, ou des matériaux de groupe III/V et ses composés binaires, tertiaires et quaternaires ou des matériaux de groupe II/VI et ses composés binaires, tertiaires et quaternaires.

8. Le transistor à effet de champs tunnel (NW-TFET) selon l'une quelconque des revendications précédentes dans lequel ledit second matériau est un matériau semiconducteur comprenant du germanium ou Si₁₋ₓGeₓ avec x>0.5.

9. Le transistor à effet de champs tunnel (NW-TFET) selon l'une quelconque des revendications précédentes dans lequel ledit second matériau est un second matériau semiconducteur ayant une bande interdite inférieure au premier matériau semiconducteur.

10. Le transistor à effet de champs tunnel (NW-TFET) selon l'une quelconque des revendications précédentes dans lequel ledit second matériau a une affinité électronique qui est différente de l'affinité électronique du premier matériau semiconducteur.

11. Le transistor à effet de champs tunnel (NW-TFET) selon l'une quelconque des revendications précédentes dans lequel ledit second matériau est une second matériau semiconducteur, dans lequel le second matériau semiconducteur est sélectionné pour avoir une affinité électronique inférieure au premier matériau semiconducteur lorsque son type de conductivité est de type p ou dans lequel ledit second matériau semiconducteur est sélectionné pour avoir une affinité électronique supérieure au premier matériau semiconducteur lorsque son type de conductivité est de type n.

12. Le transistor à effet de champs tunnel (NW-TFET) selon les revendications 1 à 5 dans lequel ledit second matériau est sélectionné parmi au moins l'un du groupe des métaux (AI, W, Ta, Ti, Ru, Pd, Rh, Re, Pt, et leurs alliages), des siliciures, des germaniures, des nitrures de métal, des oxydes conducteurs, des métaux de siliciure, des germaniures de métal et leurs alliages et mélanges.

13. Le transistor à effet de champs tunnel (NW-TFET) selon l'une quelconque des revendications précédentes, dans lequel le diamètre de l'au moins une nanostructure monocristalline allongée est entre 1 et 500 nm, de préférence entre 2 et 200 nm.

14. Le transistor à effet de champs tunnel (NW-TFET) selon l'une quelconque des revendications précédentes, dans lequel la longueur de l'au moins une nanostructure monocristalline allongée est entre 5 nm et 2 µm, de préférence entre l0nmetl 1 pm.

15. Le transistor à effet de champs tunnel (NW-TFET) selon l'une quelconque des revendications précédentes dans lequel ladite structure d'électrode de commande (8, 7 ; 23, 24) comprend un diélectrique d'électrode de commande (8, 23) sélectionné parmi au moins l'un de l'oxyde à base de silicium, de l'oxyde d'aluminium, des oxydes à k élevé, des silicates et des silicates nitrurés de métaux de transition.

16. Le transistor à effet de champs tunnel (NW-TFET) selon la revendication 15 dans lequel ledit diélectrique d'électrode de commande (8, 23) est un oxyde d'hafnium.

17. Le transistor à effet de champs tunnel (NW-TFET) selon l'une quelconque des revendications 15 ou 16, dans lequel ladite structure d'électrode de commande (8, 7 ; 23, 24) comprend un contact d'électrode de commande fait d'un métal conducteur sélectionné parmi au moins l'un du poly silicium, du poly germanium, un métal ou un alliage de métal, des nitrures métalliques, des nitrures métal-silicium, des oxydes conducteurs, des métaux entièrement silicidés, des métaux entièrement germanidés, des métaux à travail de sortie ajustable, des métaux conçus pour obtenir un travail de sortie de grille particulier.

18. Le transistor à effet de champs tunnel (NW-TFET) selon la revendication 17, dans lequel ledit contact d'électrode de commande est fait d'un métal dont le travail de sortie a été spécifiquement conçu pour le premier matériau semiconducteur, le second matériau, le diélectrique d'électrode de commande et l'épaisseur du diélectrique d'électrode de commande.

19. Le transistor à effet de champs tunnel (NW-TFET) selon la revendication 3 ou une revendication dépendante de la revendication 3, dans lequel ledit contact électrique sur chacune de la première région d'électrode principale (3 ; 22) et de la seconde région d'électrode principale (9 ; 25) est fait d'un matériau conducteur qui est sélectionné parmi au moins l'une d'une structure contenant du siliciure, d'une structure contenant du germaniure, d'une structure contenant un métal, du poly silicium ou une de leur combinaison.

20. Le transistor à effet de champs tunnel (NW-TFET) selon la revendication 19, dans lequel ledit contact électrique est fait d'une combinaison d'un métal avec un siliciure.

21. Le transistor à effet de champs tunnel (NW-TFET) selon l'une quelconque des revendications précédentes dans lequel la longueur de ladite région de canal (4, 21) est dans la plage de 1 nm à 1000 nm, de préférence dans la plage de 1 nm à 100 nm.

22. Le transistor à effet de champs tunnel (NW-TFET) selon l'une quelconque des revendications précédentes dans lequel l'épaisseur du diélectrique de grille (8) est dans la plage de 0,5 nm à 20 nm.

23. Transistor à effet de champs tunnel (NW-TFET) selon l'une quelconque des revendications précédentes dans lequel le niveau de dopage de la première région d'électrode principale (3 ; 22) et de la seconde région d'électrode principale (9 ; 25) est dans la plage de 10¹⁸/cc à 10²¹/cc, de préférence dans la plage de 10¹⁹/cc à 5x10²⁰/cc.

24. Le transistor à effet de champs tunnel (NW-TFET) selon l'une quelconque des revendications précédentes dans lequel le niveau de dopage de la région de canal (4, 21) est dans la plage de non dopé à un dopage de 10¹⁴/cc.

25. Une méthode pour fabriquer un dispositif semiconducteur de transistor à effet de champs tunnel à nanofil monocristallin allongé (NW-TFET) comprenant les étapes de :
- fournir un substrat (1) reposant sur un plan,
- faire croître une structure de nanofil monocristallin allongé, ladite nanostructure monocristalline allongée ayant une première région d'électrode principale (3 ; 22) d'un premier matériau semiconducteur, une seconde région d'électrode principale (9 ; 25) d'un second matériau différent du premier matériau semiconducteur, et une région de canal (4 ; 21) entre la première région d'électrode principale (3 ; 22) et la seconde région d'électrode principale (9 ; 25), la région de canal (4 ; 21) étant d'un matériau semiconducteur, dans lequel la seconde région d'électrode principale est une hétérosection de ladite structure de nanofil qui s'interface avec ladite région de canal au moyen d'une interface, le matériau de l'hétérosection et/ou la coupe transversale du nanofil étant telle que ladite interface est sensiblement sans défaut ;
- doper sélectivement ladite première région d'électrode principale (3 ; 22) à un niveau de dopage élevé avec des dopants d'un premier type de conductivité, doper sélectivement ladite région de canal (4 ; 21) avec un niveau de dopage étant dans la plage de non dopé à 10¹⁶/cc, et doper sélectivement ladite seconde région d'électrode principale (9 ; 25) à un niveau de dopage élevé avec des dopants d'un second type de conductivité, le premier type de conductivité étant différent du second type de conductivité, et
- fournir une structure d'électrode de commande (8, 7 ; 23, 24) sur la région de canal.

26. La méthode de la revendication 25 dans laquelle ledit substrat (1) est une plaquette de Si.

27. L'utilisation de la méthode de l'une quelconque des revendications 25 ou 26 pour former un dispositif semiconducteur de transistor à effet de champs tunnel à nanostructure monocristalline allongée (NW-TFET) selon l'une quelconque des revendications 1 à 24.
